# EUROPEAN PATENT APPLICATION

(11) **EP 4 657 514 A1**
(43) Date of publication of application: **03.12.2025**
(21) Application number: 25178976.4
(22) Date of filing: 27.05.2025
(51) Int. Cl.: H01L 21/677, H01L 21/67

(54) **WAFER CASSETTE LOADING AND UNLOADING SYSTEM FOR AN EPITAXIAL REACTOR WITH COAXIAL ACTUATION SYSTEM AND AN EPITAXIAL REACTOR**

(30) Priority: 30.05.2024 IT 202400012361; 11.12.2024 IT 202400028128
(71) Applicant: LPE S.p.A., 20021 Baranzate (MI) (IT)
(72) Inventor: SANTOS, E. Miguel Reiner, I-20021 BARANZATE, MILANO (IT); COREA, Francesco, I-20021 BARANZATE, MILANO (IT); MESCHIA, Maurilio Giuseppe, I-20021 BARANZATE, MILANO (IT)
(74) Representative: Di Biase, Fabio

(57) **Abstract**

A system (1) for loading and unloading wafer (3) cassettes (2) for an epitaxial reactor (4), the system (1) includes a carousel platform (5), configured to transport at least one cassette (2), wherein the carousel platform (5) is pivotally able to be connected to the epitaxial reactor (4) around a carousel axis (7); a carousel actuator (6), configured to drive the rotation of the carousel platform (5) around the carousel axis (7) in relation to the epitaxial reactor (4); at least one support platform (8), suitable to support at least one cassette (2), wherein at least one support platform (8) is pivotally connected to the carousel platform (5) around a rotation axis (9) that differs from the carousel axis (7); a rotation actuator (10), configured to drive the rotation of at least one support platform (8) around the rotation axis (9) relative to the carousel platform (5).

## Description

### Field of Invention

The present invention relates to a wafer cassette loading and unloading system for an epitaxial reactor, and an epitaxial reactor comprising such a loading and unloading system.

### State of the Art

Wafers intended to undergo epitaxial deposition processing of semiconductor material are generally stored and transported within cassettes, in which the wafers are stacked horizontally and spaced apart from each other.

These cassettes generally include a front side, accessible externally for loading and unloading wafers from the cassette, and an opposite rear side, totally or at least partially enclosed.

They are known to inventors of epitaxial reactors equipped with wafer cassette loading and unloading systems.

These loading and unloading systems known to the inventors include a platform pivotally hinged to a shaft, onto which at least one wafer cassette can be loaded.

The platform is pivotable between a first operating position, where the platform faces outwards from the epitaxial reactor so that the wafer cassette can be loaded or unloaded from the outside, and a second operating position, in which the platform faces inward towards the epitaxial reactor so that the wafers contained in the cassette can be manipulated by automated components of the epitaxial reactor, such as a handling robot.

It is well known to inventors that at least two wafer cassettes can be loaded onto the platform, adjacent to each other, so that the wafers contained in one cassette are intended to be used for test processes or tests, while the wafers contained in the other cassette are instead intended for final processing.

A wafer cassette loading and unloading system of this type is difficult to interface with an automated loading and unloading system, such as an SMIF, AGV or AMR system (English acronyms or abbreviations for load port transfer Standard Mechanical InterFace, Automated Guided Vehicle, Automated Mechanical Robot). In particular, it is complex or impractical to load and unload a second wafer cassette adjacent to a first wafer cassette. Therefore, this loading and unloading system requires manual loading and unloading of wafer cassettes by operators.

Additionally, the loading and unloading system for wafer cassettes of this type requires that the front side of the wafer cassette face the operator during loading and unloading. However, exposing the front side of the wafer cassette to the operator is undesirable because it increases the risk of wafer contamination or the risk of dropped and damaged wafers.

In addition, in wafer cassette loading and unloading systems of this type, detection, optical and/or electronic systems require wiring that affects the moving parts.

Therefore, there is a need for a wafer cassette loading and unloading system that can be easily interfaced with automated loading and unloading systems, such as an SMIF, AGV, or AMR system, or that can also be used manually.

There is also a need for a wafer cassette loading and unloading system that simplifies the loading and unloading of one or more wafer cassettes.

There is also a need to have a wafer cassette loading and unloading system that minimizes the risk of contamination or damage to wafers that are to be subjected or have already been subjected to epitaxial deposition processing.

There is also a need for a wafer cassette loading and unloading system that has a compact automation system.

There is also a need for an assembly for the detection of non-contact wafer cassettes, i.e. without wiring that interferes with moving parts, and a wafer cassette loading and unloading system that includes said assembly.

### Solution

The purpose of the present invention is to provide a wafer cassette loading and unloading system for an epitaxial reactor, and an epitaxial reactor including the loading and unloading system, so that at least some of the problems highlighted in the prior art are solved.

A particular purpose of the present invention is to provide a wafer cassette loading and unloading system for an epitaxial reactor, and an epitaxial reactor comprising the loading and unloading system, which can be easily interfaced with automated loading and unloading systems, or which can also be operated manually.

A further particular purpose of the present invention is to provide a wafer cassette loading and unloading system for an epitaxial reactor, and an epitaxial reactor comprising the loading and unloading system, which simplifies loading and unloading of one or more wafer cassettes.

A further particular purpose of the present invention is to provide a wafer cassette loading and unloading system for an epitaxial reactor, and an epitaxial reactor comprising the loading and unloading system, which minimizes the risk of contamination or damage to wafers that are to be subjected, or that have already been subjected, to epitaxial deposition processing.

A further particular purpose of the present invention is to provide a wafer cassette loading and unloading system for an epitaxial reactor and an epitaxial reactor, comprising a loading and unloading system, which has a small footprint and reduced complexity, and also allows wafer cassettes to be transported closer to an epitaxial reactor handling robot, thus avoiding unwanted stresses on the handling robot.

A additional particular purpose of the present invention is to make available an assembly for the detection of contactless wafer cassettes, a wafer cassette loading and unloading system for an epitaxial reactor comprising the non-contact wafer cassette detection assembly, and an epitaxial reactor comprising the loading and unloading system. This is intended to eliminate issues of entanglement and unwanted traction problems that a contact detection system would present.

This and other purposes are achieved by a wafer cassette loading and unloading system for an epitaxial reactor, and an epitaxial reactor comprising the loading and unloading system, according to the independent claims.

The dependent claims relate to preferred and advantageous implementations of the present invention.

### Figures

To better understand the invention and appreciate its advantages, some of its illustrative and non-limiting forms of implementation will be described below, referencing the accompanying figures, wherein:
- Figures 1A and 1B are schematic perspective views of a wafer cassette loading and unloading system, in a first and second operating position, according to the state of the art known to the inventors;
- Figure 2 is a schematic perspective lower view of a wafer cassette loading and unloading system, according to one form of implementation of the invention (where, for clarity, the assembly for contactless detection of wafer cassettes has been omitted);
- Figure 3 is a schematic perspective top view of the wafer cassette loading and unloading system depicted in Figure 2;
- Figure 4 is a schematic view of a cross-section of the wafer cassette loading and unloading system depicted in Figure 2;
- Figure 5 is a schematic side view of the wafer cassette loading and unloading system depicted in Figure 2;
- Figure 6 is a schematic section of an assembly for contactless detection of wafer cassettes, according to an implementation of the invention, illustrated in two different configurations (left to right, respectively, with cassette abutting and not abutting);
- Figure 7 is a schematic view of a cross-section of the wafer cassette loading and unloading system, according to one implementation of the invention;
- Figure 8 is a schematic view of a cross-section of the wafer cassette loading and unloading system, according to one implementation of the invention;
- Figure 9 is a schematic top view of a portion of an epitaxial reactor, according to one implementation of the invention.
- Figure 10 is a schematic top view of a portion of an epitaxial reactor, according to one implementation of the invention.

It is understood that the present invention is not limited by the specific implementations illustrated in the accompanying drawings and that its scope of protection is solely determined by the content of the claims. It is also noted that, in this description, the same numbers refer substantially to the same elements and, according to the above rules, the description can be made by citing the content shown in different drawings. In order to make the drawings clearer, not all elements are represented and/or depicted at scale from time to time.

### Description of some preferred examples implemented

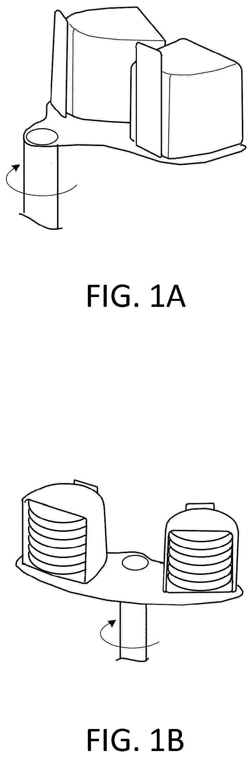

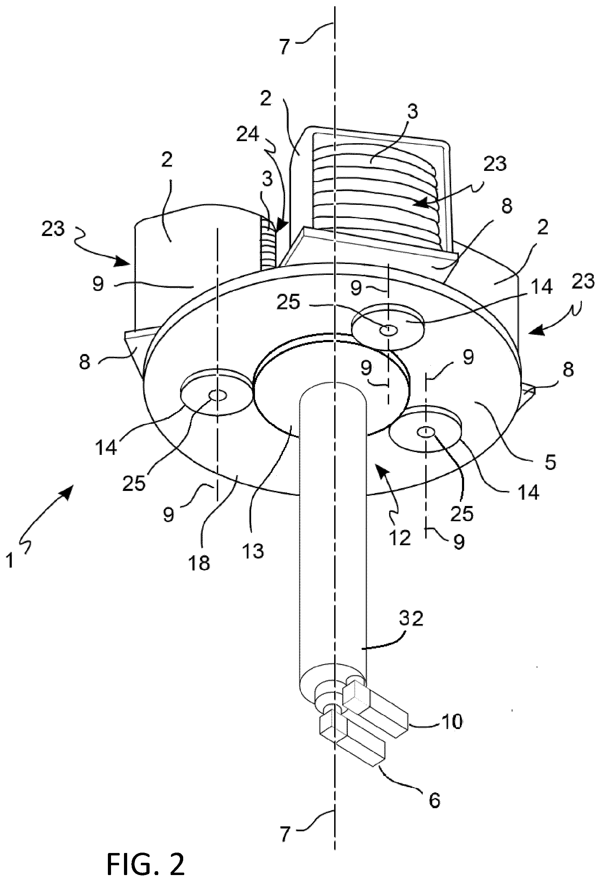

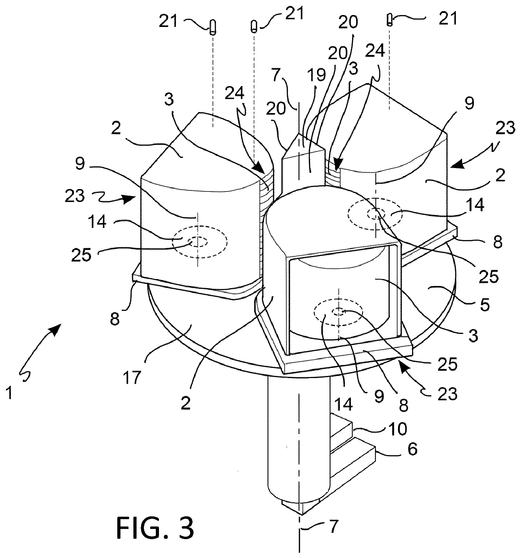

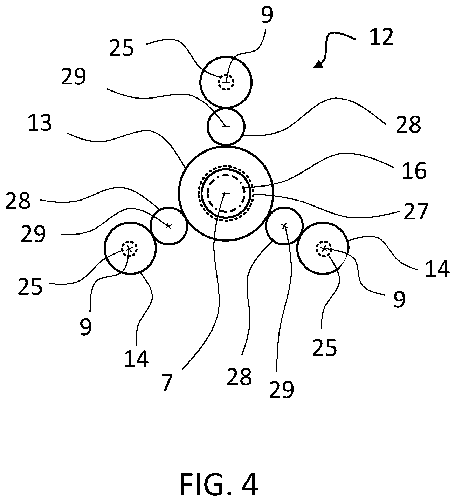

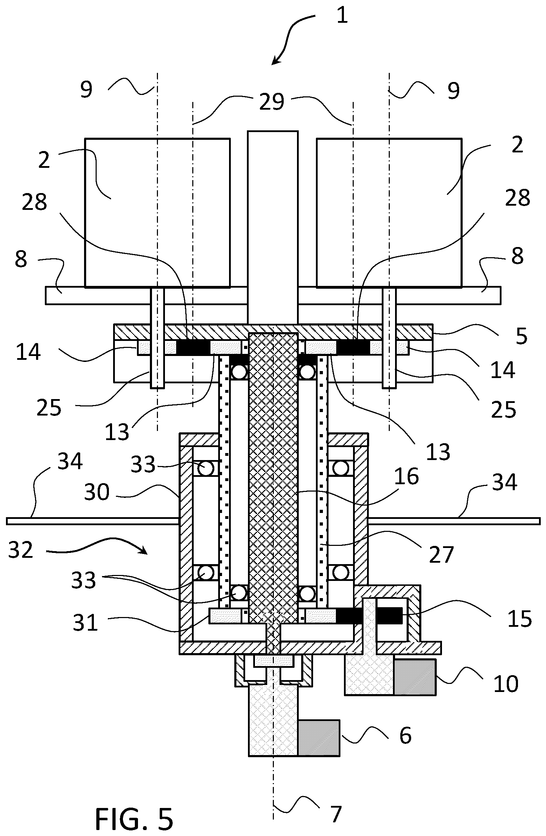

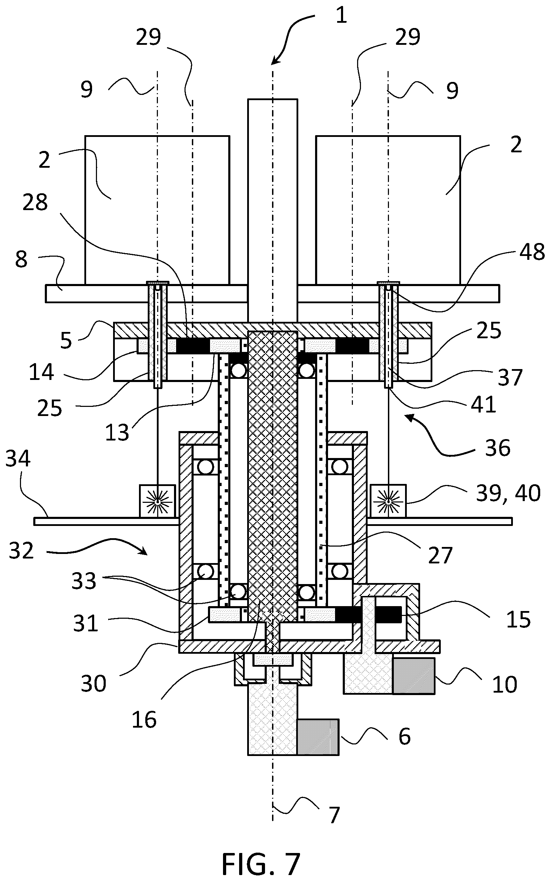

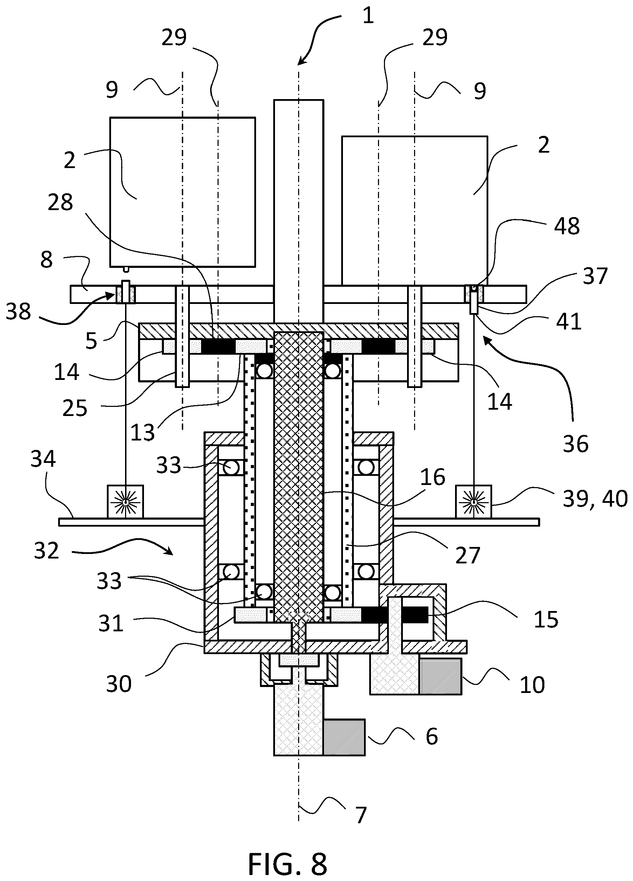

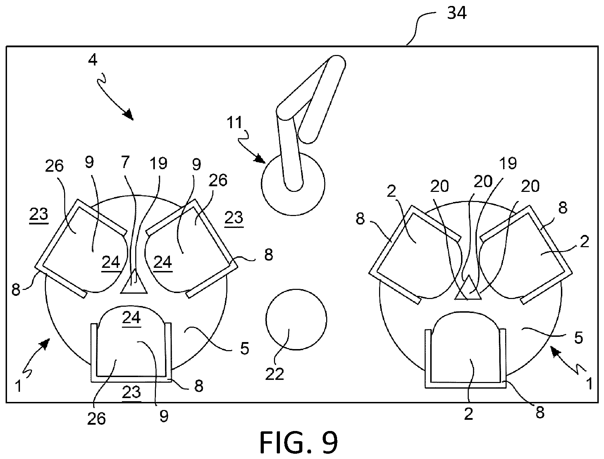

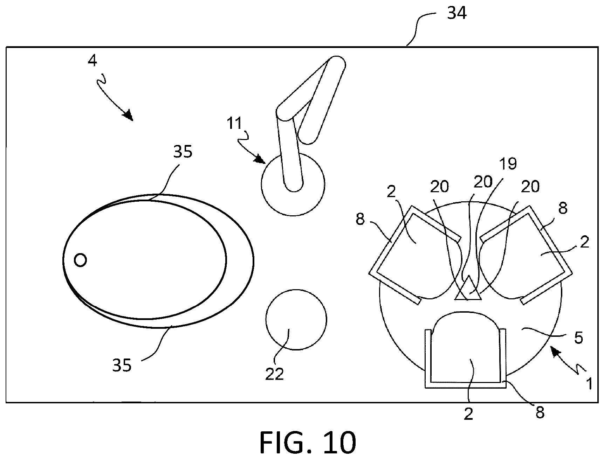

The present patent application for invention references the priority of Italian patent application 102024000028128 which is incorporated by reference in its entirety, and in particular claims 1-20, Figures 1-10, and paragraphs [00167]-[00216] and paragraphs [00027]-[00038] are incorporated by reference.

The present patent application for invention also references the priority of Italian patent application 102024000012361 which is incorporated by reference in its entirety, and in particular claims 1-16, Figures 1-7, and paragraphs [00025]-[00184] are incorporated by reference.

With reference to the figures, a wafer cassette loading and unloading system is generally indicated with the reference number 1.

The loading and unloading system 1 is configured to enable the loading and unloading of wafer 3 cassettes 2 into an epitaxial reactor 4.

Generally, cassettes 2 include a front side 23, accessible from the outside for the loading and unloading of wafers 3 from cassette 2, and an opposite rear side 24 at least partially closed.

Preferably, the cassettes 2 allow the wafers 3 to be stacked one above the other in a vertical direction when the system 1 is in use.

The system 1 comprises a carousel platform 5, configured to transport at least one cassette 2.

The carousel platform 5 is pivotally able to be connected to the epitaxial reactor 4 around a carousel axis 7.

The carousel axis 7 is substantially transverse to the carousel platform 5.

The system 1 also includes a carousel actuator 6.

The carousel actuator 6 is configured to drive a rotation of the carousel platform 5 around the carousel axis 7. Specifically, the carousel actuator 6 is configured to operate a rotation of the carousel platform 5 in relation to the epitaxial reactor 4, around the carousel axis 7.

In this way, the carousel platform 5 is capable of transporting at least one wafer 3 cassette 2 from a first operating position to a second operating position, via the rotation of at least one cassette 2 around the carousel axis 7. Specifically, the first operating position may correspond to a position where the cassette 2 can be loaded or unloaded from the epitaxial reactor 4 in an automated or manual manner. The second operating position may correspond to a position where the wafers 3 from the cassette 2 are able to be moved by automatic components of the epitaxial reactor 4, such as a handling robot 11.

Rotation of the carousel platform 5 with respect to the epitaxial reactor 4 refers specifically to the rotation of the carousel platform 5 relative to a fixed frame of the epitaxial reactor 4.

According to one aspect of the invention, the system 1 also includes at least one support platform 8, adapted to support at least one wafer 3 cassette 2.

In particular, the support platform 8 is adapted to support a single cassette 2 out of the one or more cassettes 2 that can be transported by the carousel platform 5.

At least one support platform 8 is pivotally connected to the carousel platform 5 around a rotation axis 9.

The rotation axis 9 is distinct from the carousel axis 7.

The rotation axis 9 is essentially parallel to the carousel axis 7.

Furthermore, the system 1 includes a rotation actuator 10.

The rotation actuator 10 is configured to operate a rotation of at least one support platform 8 around the rotation axis 9. Specifically, the rotation actuator 10 is configured to operate a rotation of at least one support platform 8 in relation to the carousel platform 5, around the rotation axis 9.

Furthermore, the system 1 comprises a carousel shaft 16, configured to receive a rotary motion from the carousel actuator 6, extending along the carousel axis 7 and coaxial with the carousel axis 7.
The system 1 further comprises a primary rotation shaft 27, configured to receive a rotary motion of the rotation actuator 10. The primary rotation shaft 27 is extended along the carousel axis 7 and coaxial to the carousel axis 7 and the carousel shaft 16.

The number of support platforms of the system 1 can be advantageously chosen equal to the maximum number of cassettes that are intended to be kept available at reactor 4. This number may also vary depending on the number of reaction chambers contained within the reactor.

In general, the inventors have observed that the present invention works particularly well with a number of cassettes between 2 and 8 and a number of support platforms between 2 and 8.

Advantageously, a system 1 configured in this way enables easy loading and unloading of one or more wafer 3 cassettes 2, either by automated systems such as SMIF, AGV, or AMR or manually. In fact, a system 1 configured in this way allows one or more cassettes 2 to be loaded or unloaded in an essentially identical first operating position for each cassette 2 and conveniently able to be positioned for automated or manual loading, thus simplifying loading and unloading operations.

With additional advantage, the system 1 thus configured allows the carousel platform 5 to independently rotate around the carousel axis 7, and the support platform 8 around the rotation axis 9, thereby adapting to the system (automatic or manual) used for handling cassettes and/or wafers. For example, it may be advantageous to have a different orientation of cassettes 2 on support platform 8 during loading, unloading outwards, or picking up wafers 3 from cassette 2 for insertion into the reaction chamber of epitaxial reactor 4 (and vice versa).

In particular, the system 1 thus configured allows you to choose whether the loading and unloading operations of cassettes 2 take place with cassettes 2 having the front side 23 oriented towards the outside of the carousel platform 5 or towards the inside thereof (i.e. the carousel axis 7).

As an additional advantage, the system 1 configured in this way minimizes the risk of contamination or damage to wafers 3 contained in one or more cassettes 2, as it does not require the front side 23 of the cassettes 2 to be exposed towards the operator during loading and unloading operations on the system 1. In fact, the system 1 allows the cassette 2 to be loaded or unloaded on the support platform 8 with the rear side 24 of cassette 2 facing the operator. Subsequently, when the cassette 2 is, for example, placed in the second operating position, the system 1 enables, via the rotation of the support platform 8 supporting the cassette 2 around the rotation axis 9, the rotation of the cassette 2 and thus exposing the front side 23 of the cassette 2 towards the inside of the epitaxial reactor 4, for example towards a handling robot 11 that is able to handle wafers 3 in the cassette 2.

As an additional advantage, the system 1 thus configured, compared to the state of the art systems known to the inventors, also allows the wafer 3 cassettes 2 to be moved closer to a handling robot 11 in the epitaxial reactor 4, thus avoiding unwanted stresses on the handling robot 11.

As an additional advantage, the system 1 thus configured, in comparison with the systems of art known to the inventors, allows a compact solution thanks to the coaxiality of the carousel shaft 16 and the primary rotation shaft 27. This configuration also allows the carousel platform to be rotated in the same direction at all times, allowing for less play and better motion repeatability compared to solutions where the primary rotation shaft 27 and the carousel shaft 16 are not coaxial. This also helps to avoid kinking of the power and signal cables of the carousel actuator 6 and rotation actuator 10.

As an additional advantage, the solution presented here facilitates the confinement of the clean area in which cassettes 2 are located with respect to the moving parts (bearings, sprockets, sprockets) and actuators 6 and 10, thus further minimizing the risk of contamination or damage to the wafers to be subjected, or already subjected, to epitaxial deposition treatment.

According to one implementation, the primary rotation shaft 27 is hollow and comprises, in whole or in part, the carousel shaft 16 to which it is rotatably connected. Optionally, the carousel shaft 16 is also hollow.

Advantageously, a system 1 thus configured allows for easy grouping of the main moving parts (in particular the primary rotation shaft 27 and the carousel shaft 16), minimizing the overall dimensions and reducing the areas affected by any dust or particulates generated by the movement of the main moving parts.

As an additional advantage, the system 1 thus configured lightens the main moving parts, thus limiting the energy required to move them.

According to one form of implementation, the system 1 comprises a set of coaxial shafts 32.

The coaxial shaft assembly 32 comprises at least one stator 30, the primary rotation shaft 27, and the carousel shaft 16.

The stator 30 is hollow and contains all or part of the primary rotation shaft 27, which in turn is hollow and contains all or part of the carousel shaft 16.

The coaxial shaft assembly 32 may optionally comprise: (i) one or more cover systems (shields, masks, etc.), and/or (ii) one or more sealing systems (flanges, seals, etc.), and/or (iii) one or more ball bearings 33 arranged between stator 30 and primary rotation shaft 27, respectively, and/or between primary rotation shaft 27 and carousel shaft 16.

Advantageously, a system 1 thus configured prevents or reduces contamination of the system 1 from any dust or particulates generated by the movement of the main parts (in particular the primary rotation shaft 27 and the carousel shaft 16), allowing for effective isolation, firmness and shielding of the coaxial shaft assembly 32 compared to the other parts of the system 1.

According to one implementation, the system 1 comprises a bench 34 adapted to further separate the clean area of the system 1 (intended for cassettes 2 containing wafers 3), from the gray area where the cleaning requirements are less stringent and where actuators 6 and 10 can be conveniently positioned. For example, carousel platform 5, and cassettes 2 may be located above bank 34; while carousel actuator 6 and rotation actuator 10 may be located below bank 34. Bench 34 is distinct from the carousel platform and is a fixed element.

According to one implementation form, the system 1 includes a gear mechanism 12.

The gear 12 connects the rotation actuator 10, and more precisely the primary rotation shaft 27, with at least one support platform 8.

The gear 12 is configured to rotate the support platform 8 relative to the carousel platform 5, around the rotation axis 9.

Advantageously, the gear 12 may be in whole or in part enclosed by a casing that prevents the spread of dust or particles generated during handling of the gear 12.

According to one implementation form, the system 1 comprises a motion transmission system connecting the rotation actuator 10 with at least one support platform 8, which may include drive chains and/or timing belts and/or mechanical couplings.

According to one implementation form, the system 1 includes a sprocket 13.

The sprocket 13 is pivotally connected to the carousel platform 5.

Furthermore, the sprocket 13 is positioned coaxially to the carousel axis 7. In this way, the sprocket 13 can be pivoted relative to the carousel platform 5, around the carousel axis 7.

The system 1 also includes at least one drive wheel 14.

At least one drive wheel 14 is attached to a respective support platform 8. Furthermore, the drive wheel 14 is positioned coaxially to the rotation axis 9.

The drive wheel 14 is directly engaged with or connected to the sprocket 13 via one or more idler wheels 28.

One or more idler wheels 28, if present, are designed to rotate around an idler wheel rotation axis 29, substantially parallel to the carousel axis 7 and the rotation axis 9, and distinct from them.

Furthermore, the rotation actuator 10 is operatively connected to the sprocket 13 through the primary rotation shaft 27, in order to activate a rotation of the sprocket 13 around the carousel axis 7 relative to the carousel platform 5.

Advantageously, configuring the system 1 in this manner allows the cassettes 2 to be transported from a first operating position to a second operating position by a rotation of the carousel platform 5. Furthermore, through the sprocket 13 and the drive wheel 14 configured in this manner and geared together (directly or indirectly through one or more idler wheels 28), the cassette 2 is able to be independently rotated so as to expose its front 23 or rear, as required.

By way of example, the wafer 3 cassette 2 is able to be loaded on the support platform 8, in a first operating position, with the rear side 24 of the cassette 2 facing an operator or automated system. Subsequently, the cassette 2 is able to be transported from the first operating position to a second operating position by the rotation of the carousel platform 5, to which the support platform 8 is connected, relative to the epitaxial reactor 4 around the carousel axis 7, driven by the carousel actuator 6. While traveling between the first and second operating positions, or at the second operating position, the cassette 2 is able to pivot on itself so as to expose its front side 23 towards a handling robot 11 in the epitaxial reactor 4, by a rotation of the support platform 8 around the rotation axis 9 in relation to the carousel platform 5, driven by the rotation actuator 10, and in particular performed via a rotation of the drive wheel 14, integral to the support platform 8, driven by a rotation of the sprocket 13 to which the drive wheel 14 is geared.

According to one form of implementation, the sprocket 13 and at least one drive wheel 14 are essentially placed in a coplanar position.

According to one form of implementation, at least one drive wheel 14 is geared externally to the sprocket 13, with reference to the carousel axis 7.

According to one form of implementation, at least one drive wheel 14 is geared internally to the sprocket 13, with reference to the carousel axis 7.

According to one implementation, at least one idler wheel 28 is interposed between the sprocket 13 and the drive wheel 14. In this case, it is geared to both the sprocket 13 and the drive wheel 14, and allows the latter to be rotated in the same direction, either clockwise or counterclockwise.

According to one form of implementation, the rotation actuator 10 comprises a drive gear 15. The drive wheel 15 may also be a pinion.

The drive wheel 15 is geared with a second sprocket 31 different from the sprocket 13.

The second sprocket 31 is attached to the primary rotation shaft 27 and is integral to the sprocket 13.

The second sprocket 31, the primary rotation shaft 27 and the sprocket 13 are adapted to rotate about the carousel axis 7.

The drive gear 15 is therefore configured to indirectly command a rotation of the sprocket 13 around the carousel axis 7.

According to one form of implementation, the sprocket 13 and at least one drive wheel 14 are essentially placed in a coplanar position.

According to one form of implementation, at least one drive gear 15 is externally engaged with the second sprocket 31, in reference to the carousel axis 7, and is coplanar with it.

According to one form of implementation, at least one drive gear 15 is internally engaged with the second sprocket 31, in reference to the carousel axis 7.

According to one form of implementation, the sprocket 13, the second sprocket 31, at least one drive wheel 14, and the drive gear 15 have cylindrical or helical teeth.

According to one implementation, the carousel shaft 16 is attached to the carousel platform 5.

Additionally, the carousel shaft 16 is interposed between the carousel actuator 6 and the carousel platform 5.

Specifically, the carousel shaft 16 is configured to receive a rotary motion from the carousel actuator 6 and transmit the rotary motion to the carousel platform 5, so as to drive the rotation of the carousel platform 5 around the carousel axis 7.

According to one form of implementation, the carousel shaft 16 extends passing through the sprocket 13.

According to one form of implementation, the carousel shaft 16 is positioned opposite the support platforms 8, in relation to the carousel platform 5.

According to one form of implementation, each support platform 8 comprises a respective secondary rotation shaft 25. The secondary rotation shaft 25 extends coaxially to the respective rotation axis 9.

The secondary rotation shaft 25 is attached to the support platform 8 and a respective drive wheel 14.

According to one form of implementation, the secondary rotation shaft 25 extends through the carousel platform 5. In this way, the secondary rotation shaft 25 integrally connects the support platform 8 to the respective drive wheel 14, positioned opposite one another with respect to the carousel platform 5.

According to one form of implementation, the carousel actuator 6 is a servomotor.

According to one form of implementation, the carousel actuator 6 is connected to one end of the carousel shaft 16 opposite to one end of the carousel shaft 16 to which the carousel platform 5 is connected.

According to one form of implementation, the rotation actuator 10 is a servomotor.

According to one implementation, the carousel actuator 6 and/or the rotation actuator 10 are provided with a motor conditioner (encoder) to know the absolute position of the cassettes 2.

According to one form of implementation, the carousel platform 5 is a plate, for example circular in shape and coaxial to the carousel axis 7.

The term "platter" refers to a regular rod or prism, having parallel bases and planes of circular or polygonal shape.

According to one implementation, the thickness of the platter is less than the side of the square having an area equivalent to the area of the base of the plate.

According to one form of implementation, the support platform 8 is a plate. According to one form of implementation, the support platform 8 is a plate that is circular or prism shaped or essentially shaped to reflect the shape of a lower wall of the cassettes 2.

According to one form of implementation, at least one support platform 8 is positioned opposite the sprocket 13 and at least one drive wheel 14, relative to the carousel platform 5.

According to one form of implementation, the system 1 comprises a plurality of support platforms 8 pivotally connected to the carousel platform 5 around the respective and distinct rotational axes 9.

The respective rotation axes 9 are parallel to each other and parallel to the carousel axis 7.

According to one form of implementation, the system 1 comprises three support platforms 8.

Advantageously, one of the three support platforms 8 may be intended to support and transport a wafer 3 cassette 2 for testing procedures or tests, another of the three support platforms 8 may be intended to support and transport a wafer 3 cassette 2 to be subjected to final processes in an epitaxial reactor reaction chamber 4, and another of the three support platforms 8 may be intended to support and transport a wafer 3 cassette 2 into an epitaxial reactor reaction chamber 4. Therefore, a system 1 configured in this way can be used in epitaxial reactors 4 having more than one reaction chamber, and allows for a quick and easy replenishment or withdrawal of wafers 3 to be processed or treated.

According to one form of implementation, the support platforms 8 are positioned angularly equidistant to each other on the carousel platform 5.

According to one form of implementation, the three support platforms 8 are positioned essentially equidistant 180° from each other on the carousel platform 5.

According to one form of implementation, the three support platforms 8 are positioned essentially equidistant 90° from each other on the carousel platform 5.

According to one form of implementation, the three support platforms 8 are positioned essentially equidistant 120° from each other on the carousel platform 5.

According to one form of implementation, the respective drive wheels 14 of the plurality of support platforms 8 are engaged with the same sprocket 13.

Advantageously, this configuration allows the rotation of all support platforms 8 to be driven by the rotation of the sprocket 13 alone, to which the drive wheels 14 connected to the respective support platforms 8 are geared.

According to one form of implementation, the respective drive wheels 14 of the plurality of support platforms 8 are engaged with an idler wheel 28 and each idler wheel 28 is engaged with the same sprocket 13.

Advantageously, such a configuration allows the drive wheels 14 to be rotated in the same direction of rotation as the sprocket 13, when the number of idler wheels 28 for each drive wheel 14 is odd. Preferably, only one idler wheel 28 is engaged with each drive wheel 14 and the sprocket 13.

With further advantage, the configuration described herein allows the rotation of all support platforms 8 to be operated by the rotation of the sprocket 13 alone. With further advantage, the configuration described herein allows the ratio of the diameter of the sprocket 13 to the diameter of the drive wheel 14 to be reduced.

According to one implementation, the primary rotation shaft 27 is attached to the sprocket 13 and the second sprocket 31, and is interposed between the rotation actuator 6 and the carousel platform 5.

The primary rotation shaft 27 is configured to transmit the rotary motion to the gear 12, so that the drive rotation of the secondary rotation shaft 25, and, consequently, the support platform 8 about the rotation axis 9.

According to one form of implementation, the primary rotation shaft 27 is positioned opposite the support platforms 8, in relation to the carousel platform 5.

According to one form of implementation, the carousel platform 5 comprises a top wall 17 and an opposite lower wall 18.

The top wall 17 of the carousel platform 5 faces at least one support platform 8. Specifically, the support platforms 8 are positioned above the upper wall 17 of the carousel platform 5.

The lower wall 18 of the carousel platform 5 faces the sprocket 13. According to one form of implementation, the lower wall 18 is also facing at least one drive wheel 14, the idler wheel 28 if present, and the carousel shaft 16.

According to one form of implementation, the system 1 comprises a reflector element 19.

The reflector element 19 comprises at least one reflective surface 20.

According to one form of implementation, the reflective surface 20 is essentially positioned parallel to the carousel axis 7.

Advantageously, the reflector element 19 is adapted to reflect a laser beam from the epitaxial reactor 4, for example emitted by the handling robot 11, and used to detect wafers 3 contained in the cassette 2 supported by the support platform 8. For example, the laser beam emitted by the handling robot 11 may be reflected by the reflector 19 in the direction of the partially open rear side 24 of the cassette 2, so as to detect the number and placement of the wafers 3 contained in the cassette 2.

According to one form of implementation, the reflector element 19 includes a number of reflective surfaces 20 equal to the number of support platforms 8 connected to the same carousel platform 5.

According to one form of implementation, each reflective surface 20 is extended over a plane parallel to the carousel axis 7.

According to one form of implementation, each reflective surface 20 is positioned in line with a respective support platform 8, facing the respective support platform 8.

According to one form of implementation, each reflective surface is positioned between the carousel axis 7 and a support platform 8.

According to the form of implementation in which the system includes three support platforms 8, the reflector element 19 comprises three reflective surfaces 20 positioned parallel to the carousel axis 7 and arranged essentially in the shape of an equilateral triangle.

According to the form of implementation in which the carousel platform 5 is a circular plate, each reflective surface 20 is positioned parallel to the carousel axis 7 and transverse to a radial axis of the carousel platform 5.

According to the implementation in which the carousel platform 5 is a triangular plate with three sides of equal length, each reflective surface 20 is positioned parallel to the carousel axis 7 and parallel to the side of the triangular carousel platform 5.

According to one form of implementation, the reflector element 19 includes a support that is suitable for supporting the one or more reflective surfaces 20.

According to one form of implementation, the reflector element 19 is positioned at the top wall 17 of the carousel platform 5.

According to one form of implementation, the reflector element 19 is positioned at the carousel axis 7.

According to one form of implementation, the reflector element 19 is positioned essentially concentrically with the carousel axis 7.

According to one form of implementation, the reflector element 19 is connected to the top wall 17 of the carousel platform 5.

According to one form of implementation, the reflector element 19 extends along the carousel axis 7 opposite to the lower wall 18 of the carousel platform 5.

According to one form of implementation, the carousel actuator 6 and the rotation actuator 10 are positioned opposite the support platforms 8 relative to the carousel platform 5.

According to one form of implementation, the carousel actuator 6 and the rotation actuator 10 are positioned below the lower wall 18, comprised within the vertically occupied footprint, i.e., in the direction of the carousel axis 7, relative to the carousel platform 5.

According to one form of implementation, the system 1 includes a detection system 21.

The detection system 21 is configured to detect the positioning and/or orientation of one or more support platforms 8, or one or more cassettes 2 supported by the respective support platforms 8, relative to the carousel platform 5.

Advantageously, by means of the detection system 21 it is possible to check that the cassettes 2, supported by the support platforms 8, are correctly oriented during the handling and transportation phases of the cassettes. By way of example, the detection system 21 can detect whether the cassette 2 is correctly positioned with the front side 23 of the cassette 2 facing the handling robot 11 when cassette 2 is in the second operating position, or that cassette 2 is correctly positioned with the back side 24 of the cassette 2 facing the operator when the cassette 2 is in the first operating position.

According to one form of implementation, the detection system 21 comprises at least one detection device, such as a laser sensor or an image detector.

According to one form of implementation, one or more detection devices are positioned above one or more support platforms 8, in relation to the carousel platform 5, facing the support platforms 8.

According to an additional form of implementation, one or more detection devices are positioned in line with the top wall 17 of the carousel platform 5, facing the support platforms 8.

According to an alternative and advantageous implementation, one or more detection devices are positioned below one or more support platforms 8, in relation to the carousel platform 5, facing the support platforms 8.

According to one implementation, the cassette loading and unloading system 1 comprises at least one assembly 36 for non-contact detection of the presence of a wafer 3 cassette 2 located in a support platform housing 8.

Assembly 36 may advantageously be implemented in all implementations of the cassette loading and unloading system 1 described above.

In particular, the assembly 36 may be used as an alternative or in addition to the detection system 21.

The assembly 36 may also constitute a particular implementation of the detection system 21.

Assembly 36 comprises:
- a first movable element 37 adapted to assume: (i) at least a first predefined position in the absence of a cassette, and (ii) at least a second predefined position when the cassette is correctly positioned within a housing;
- an actuating mechanism 38 (preferably integrated into the support platform 8), adapted to contact the cassette when it is located in its housing and adapted to move the first movable element from the first predetermined position to the second predefined position upon contact with the cassette, when it is correctly positioned inside the housing;
- a source 39 of electromagnetic radiation;
- a sensor 40 adapted to detect said electromagnetic radiation;
- a reflector 41 connected or integral to the first movable element.

Source 39, sensor 40 and reflector 41 are mutually positioned and oriented so that the reflector receives electromagnetic radiation emitted from source 39 and reflects it on sensor 40 at least when the movable element 37 is located in the second predefined position.

The sensor 40, by detecting the electromagnetic radiation signal emitted by the source 39, can transform said signal into a position data for the reflector 41, for example by means of triangulation calculations.

Preferably, the first movable element 37 is connected or integral with the support platform 8.

Preferably, the source 39 and/or the sensor 40 are not in contact with or physically connected to either the support platform 8 or the carousel platform 5. Preferably, the source 39 and/or sensor 40 are not integral with either the support platform 8 or the carousel platform 5. They are preferably located in predefined fixed positions, as determined, for example, during instrument calibration. In case of use with the system 1, they may advantageously be positioned on bench 34.

Preferably, the reflector 41 is integral with the first movable element 37.

A reflector is an element capable of modifying the direction of electromagnetic radiation emitted by a source and incident upon it. The reflector may for example comprise a reflective surface.

Preferably, the drive mechanism 38 does not require power. For example, it may be a mechanism consisting essentially of mechanical gears.

Advantageously, the assembly 36 described above allows operation in a contactless manner, avoiding the presence of power and drive cables.

In particular, the assembly 36 does not require wiring at support platform 8 and/or carousel platform 5.

The assembly 36 therefore has an advantage over known detection systems, particularly when it is included in system 1. In fact, due to the multiple rotary movements affecting the various elements of the system 1 (due to the compound movement around the carousel axis 7 and the rotation axes 9), the presence of cables on the support the platform 8 and/or on the carousel platform 5 can generate inconvenient obstructions, unwanted pulling and interference with the operation of the system 1.

Advantageously, the system 1 may comprise an assembly 36 for each cassette, i.e. for each housing thereof on the support platform 8, so as to verify the presence and/or correct positioning.

Alternatively, the system 1 may comprise a first assembly 36 for a first cassette, and a number of modified assemblies corresponding to the remaining number of cassettes, if any. These modified assemblies, or contact detection devices, correspond to the private assembly 36 of the source 39 and the sensor 40. They may use the source 39 and the sensor 40 of the assembly 36, when the support platform 8 rotates around the carousel axis 7.

In general, the sensor 40 may be connected, via wiring or wireless communication, to a data transmission system to track, record and/or process the position of the reflector 41 and/or output a signal reporting the absence and/or presence of the cassette based on said position.

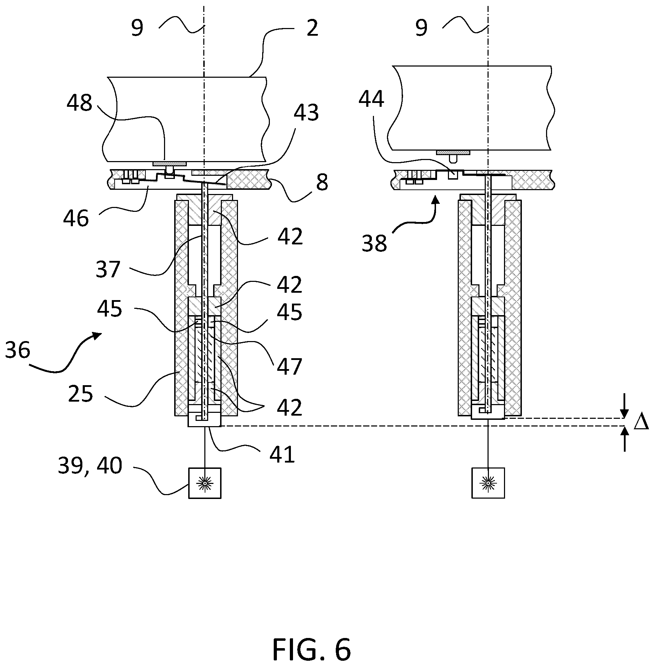

By virtue of its connection with the first movable element, the reflector 41 is able to undergo shifts based Δon the different positions assumed by the first movable element 37, as for example illustrated in Figure 6.

In general, the first movable element 37 may advantageously be adapted to assume a plurality of predefined positions.

For example, bypassing the first predefined position in the absence of a cassette, several predefined positions can be identified when the cassette is correctly positioned inside the slot. One position can correspond to when the cassette is present but empty. Another position may correspond to when the cassette is present and loaded with wafers. In the latter case, additional predefined positions can be distinguished depending on wafer size and weight (6" vs. 8", for example).

According to one implementation, the source 39 is a collimated electromagnetic radiation source, preferably a visible or infrared emission laser.

According to one implementation, the actuating mechanism 38 is a push-button mechanism, preferably actuated by the weight of the cassette when it is present on the support platform 8 and correctly positioned in its housing.

Note that in general, in all the implementations described herein, each support platform 8 may advantageously be provided with at least one housing, each housing being configured to accommodate a cassette.

For example, the housing may be configured to position and secure a cassette during its use with the system 1.

For this purpose, the housing may comprise one or more protrusions and/or one or more recesses adapted to mechanically connect (e.g. by hooking or interlocking) with the corresponding and respective recesses and/or protrusions 48 of the cassette. Typically, cassettes in the area of interest are standardized and equipped with an element known as an "H-bar" that protrudes from the body of the cassette at its base.

The housing for the cassette in the support platform 8 of the system 1 may advantageously be provided with a recess (such as the opening 44) which is suitable in shape and size to receive and accommodate the "H-bar," helping to anchor the cassette to the support platform until it is removed after use.

According to an implementation in which the system comprises the secondary rotation shaft 25, the latter is hollow and the first movable member 37 is a shaft extending within the secondary rotation shaft 25.

This implementation offers a particularly compact form of assembly 36, minimizing weight and footprint and facilitating assembly.

In this case, the assembly 36 may with further advantage comprise at least one guide and/or at least one spacer 42 for positioning the first movable element 37 within the secondary rotation shaft 25.

The assembly 36 may comprise at least one elastic potential energy device 47, preloaded and adapted to maintain the first movable element 37 in the first predefined position in the absence of a cassette.

The elastic potential energy device 47 may be spring compressed via a spring pre-charge element 45.

According to one implementation, the drive mechanism 38 is a push button mechanism and comprises:
- a cavity 46 obtained within one or more support platforms 8;
- a second movable element 43, optionally elastic.

The cavity 46 has an opening 44 located in the cassette housing of the support platform 8. The opening can be configured to accommodate a protrusion 48 of the cassette 2, for example the "H-bar" of the cassette.

The second movable element 43 is located at the opening 44 and is adapted to undergo pressure under the weight of a cassette located at the opening 44 and, in response, move the first movable element 37 from the first predefined position to the second predefined position or a third predefined position.

These last default positions refer to the cassette being in empty or loaded mode (or vice versa) for a given wafer size, and do not exclude the possibility of additional default positions per loaded cassette in different wafer size cases.

The pressure exerted by the weight force of the cassette on the second movable element 43 may occur under the push of the protrusion 48 of the cassette through the opening 44 of the cavity 46. The opening 44 in fact faces the top surface of the support platform 8 at the cassette housing.

Source 39 and sensor 40 may advantageously be integrated into a single photodetector device and positioned on bench 34.

In the implementation shown in Figure 6, the second movable element 43 is an elastic sheet metal plate fixed at one end and connected at the other end to one end of the first movable element 37, which extends partly into the cavity 46.

The second movable element acts in this case as a third type of lever.

Advantageously, in the case of a second elastic movable element, the latter may be able to independently return to its initial equilibrium position upon cessation of the pressure exerted by the cassette, for example when it is removed or is incorrectly positioned.

In an additional aspect, the invention relates to the assembly 36 for contactless detection of the presence of a wafer 3 cassette 2 located in a housing of a support platform 8, according to any of the configurations described above and as set forth in the appended claims, which form an integral part of this description.

According to a further aspect of the invention, an epitaxial reactor 4 comprises at least one reaction chamber.

Wafers 3 can be inserted inside the reaction chamber to undergo epitaxial deposition processing of semiconductor material.

The epitaxial reactor 4 also includes at least one loading and unloading system 1 of wafer 3 cassettes 2 as previously described.

According to one form of implementation, the reactor 4 includes a handling robot 11.

The handling robot 11 is configured to move the wafers 3 contained in the respective cassettes 2.

Furthermore, the handling robot 11 is configured to handle the wafer carriers contained in the respective carrier cassettes 26.

According to one form of implementation, the epitaxial reactor 4 comprises at least two systems 1. According to one form of implementation, the epitaxial reactor 4 comprises at least two reaction chambers.

According to one form of implementation, the epitaxial reactor 4 comprises two reaction chambers and two systems 1.

Advantageously, one of the two systems 1 can be used to handle cassettes 2 of wafers 3 to be subjected or that have been subjected to epitaxial deposition processing, while the other of the two systems 1 can be used to handle cassettes for supports 26 containing wafer holders.

According to one form of implementation, the handling robot 11 is positioned essentially interposed between two systems 1.

According to one implementation, the epitaxial reactor 4 comprises a loading station 22 or "Centering Unit (CU)", for loading and centering the wafer 3 on the wafer holder, also called wafer support device.

According to one form of implementation, the loading station 22 is positioned at the handling robot 11. The term "corresponding" henceforth means "directly accessible"-in this case directly accessible by the handling robot 11.

According to one form of implementation, the loading station 22 is positioned interposed between two systems 1.

Advantageously, in an epitaxial reactor 4 configured in this manner, the handling robot 11 is capable of picking up a wafer holder from a respective support cassette 26 of a first system 1, and placing the wafer holder on the loading station 22. Subsequently, the handling robot 11 is able to pick up a wafer 3 from a respective cassette 2 of a second system 1, and place the wafer 3 on the wafer holder previously placed on the loading station 22. In this way, the wafer supported by the wafer holder is able to be moved by the handling robot 11 and can be transported in the direction of the one or more epitaxial reactor 4 reaction chambers.

Advantageously, in an epitaxial reactor 4 configured in this way, the cassettes 2 for wafers 3 and cassettes for the supports 26 are able to be loaded on the same system 1. The handling robot 11 is then able to pick up a wafer holder from a respective support cassette 26 in the system 1, and place the wafer holder on the loading station 22. The handling robot is then able to pick up a wafer 3 from a respective cassette 2 from the same system 1, and place the wafer 3 on the wafer holder previously placed on the loading station 22. With an additional advantage, this configuration reduces the footprints of the epitaxial reactor 4.

According to one form of implementation, the epitaxial reactor 4 comprises a single system 1.

According to one form of implementation, the epitaxial reactor 4 comprises two reaction chambers and a single system 1.

According to one form of implementation, the handling robot 11 is positioned in line with the system 1.

According to one form of implementation, the handling robot 11 is positioned equidistant between the two reaction chambers.

According to one form of implementation, the loading station 22 is positioned in line with the handling robot 11 and the system 1.

According to one implementation, the epitaxial reactor 4 comprises one or more shelves for wafer support devices 35. The number of shelves 35 can be advantageously chosen to be equal to the number of reaction chambers in the reactor.

According to one implementation, each wafer support device shelf 35 is positioned in correspondence with the handling robot 11. Advantageously, the shelves for wafer support devices 35 may be distributed vertically one above the other, ensuring space between shelves for wafer support devices.

According to an implementation of the reactor 4, the system 1 comprises bench 34. In this case, the handling robot 11, load station 22 and two shelves for wafer support devices 35 may be positioned on the bench 34.

Advantageously, in an epitaxial reactor 4 thus configured, cassettes 2 for wafers 3 and wafer support devices on shelves 35 are accessible from the same handling robot 11. The latter is then able to pick up a wafer carrier device from shelf 35, and place the wafer carrier on load station 22. The handling robot is then able to pick up a wafer 3 from a respective cassette 2 from the system 1, and place the wafer 3 on the wafer holder previously placed on the loading station 22. With further advantage, such a configuration reduces the footprints of the epitaxial reactor 4 and allows effective management, with a single system 1, a reactor 4 having one, two or more reaction chambers. With an additional advantage, this configuration reduces the footprints of the epitaxial reactor 4.

Of course, the person skilled in the art will be able to make modifications or adaptations to the present invention, without departing from the scope of the claims set forth below.

The present invention therefore comprises all the variants and combinations of the implementations described above.

In the claims, the use of the references to the numbers used in the accompanying drawings is to be understood only for the purpose of facilitating the understanding of the text, and is not to be understood in a limited sense of the specific forms of construction illustrated.

### REFERENCES

1. Wafer cassette loading and unloading system
2. Cassette
3. Wafer
4. Epitaxial reactor
5. Carousel platform
6. Carousel actuator
7. Carousel axis
8. Support platform
9. Rotation axis
10. Rotation actuator
11. Handling robot
12. Gear
13. Sprocket
14. Drive wheel
15. Drive gear
16. Carousel shaft
17. Top wall of the carousel platform
18. Lower wall of the carousel platform
19. Reflector element
20. Reflective surface
21. Detection system
22. Loading station
23. Front side of the cassette
24. Rear side of the cassette
25. Secondary rotation shaft
26. Support cassette
27. Primary rotation shaft
28. Idle wheel
29. Idle wheel rotation axis
30. Stator
31. Second sprocket
32. Coaxial shaft assembly
33. Ball bearings
34. Bench
35. Shelf for wafer support devices
36. Assembly for contactless detection of a wafer cassette
37. First moving element
38. Actuation mechanism
39. Source
40. Sensor
41. Reflector
42. Guide and/or spacer
43. Second mobile element
44. Opening
45. Spring pre-load element
46. Cavity
47. Elastic potential energy device
48. Protrusion

## Claims

1. A system (1) for the loading and unloading of wafer (3) cassettes (2) for an epitaxial reactor (4), the system (1) comprising:
- a carousel platform (5), configured to transport at least one cassette (2), wherein the carousel platform (5) is pivotally able to be connected to the epitaxial reactor (4) around a carousel axis (7);
- a carousel actuator (6), configured to drive a rotation of the carousel platform (5) around the carousel axis (7) relative to the epitaxial reactor (4);
**characterized by** the fact of understanding:
- at least one support platform (8), adapted to support at least one cassette (2), wherein at least one support platform (8) is pivotally connected to the carousel platform (5) around a rotation axis (9) that differs from the carousel axis (7);
- a rotation actuator (10), configured to operate a rotation of at least one support platform (8) around the rotation axis (9) in relation to the carousel platform (5);
- a carousel shaft (16), extended along the carousel axis (7) and coaxial to the carousel axis (7), configured to receive a rotary motion from the carousel actuator (6);
- a primary rotation shaft (27), extended along the carousel axis (7) and coaxial to the carousel axis (7) and the carousel shaft (16), configured to receive a rotary motion of the rotation actuator (10).

2. The system (1) of claim 1, wherein the primary rotation shaft (27) is hollow and comprises therein, in whole or in part, the carousel shaft (16) to which it is rotatably connected.

3. A system (1) according to claim 1 or 2, comprising an assembly of coaxial shafts (32), wherein the assembly of coaxial shafts (32) comprises at least one stator (30), and wherein the primary rotation shaft (27) and the carousel shaft (16) are, in whole or in part, contained within the stator (30).

4. System (1) according to any one of the preceding claims, comprising a gear (12) that connects the primary rotation shaft (27) with at least one support platform (8), wherein the gear (12) is configured to implement a rotation of the support platform (8) relative to the carousel platform (5) around the rotation axis (9).

5. System (1) according to any of the preceding claims, comprising a sprocket (13) rotatably connected to the carousel platform (5), in which the sprocket (13) is positioned coaxial to the carousel axis (7),
wherein the system (1) includes at least one drive wheel (14) attached to at least one support platform (8), wherein the drive wheel (14) is positioned coaxially to the rotation axis (9), and wherein the drive wheel (14) is directly engaged with the sprocket (13) or is connected to it through one or more idler wheels (28),
and wherein the rotation actuator (10) is operatively connected to the sprocket (13) through the primary rotation shaft (27), in order to activate a rotation of the sprocket (13) around the carousel axis (7) relative to the carousel platform (5).

6. System (1) according to claim 5, in which the rotation actuator (10) includes a drive wheel (15) geared with a second sprocket (31) other than the sprocket (13),
wherein the second sprocket (31) is attached to the primary rotation shaft (27) and is integral to the sprocket (13),
wherein the drive wheel (15) is configured to rotate the sprocket (13) around the carousel axis (7).

7. System (1) according to any one of the preceding claims, wherein the carousel shaft (16) is attached to the carousel platform (5) and is interposed between the carousel actuator (6) and the carousel platform (5), and wherein the carousel shaft (16) is configured to transmit rotary motion to the carousel platform (5), so as to drive the rotation of the carousel platform (5) around the carousel axis (7),
and wherein the carousel shaft (16) is extended through a sprocket (13),
and wherein, optionally, the carousel shaft (16) is positioned opposite the support platforms (8), relative to the carousel platform (5).

8. System (1) according to any of the preceding claims, in which each support platform (8) includes a respective secondary rotation shaft (25) extended coaxial to the respective rotation axis (9),
wherein the secondary rotation shaft (25) is attached to the support platform (8) and a respective drive wheel (14),
and wherein the secondary rotation shaft (25) extends through the carousel platform (5).

9. System (1) according to any one of the preceding claims, wherein the primary rotation shaft (27) is attached to the sprocket (13) and the second sprocket (31), and is interposed between the rotation actuator (10) and the carousel platform (5), and wherein the primary rotation shaft (27) is configured to transmit rotary motion to the gear (12), so as to drive the rotation of the secondary rotation shaft (25) around the rotation axis (9),
and wherein, optionally, the primary rotation shaft (27) is positioned opposite the support platforms (8), relative to the carousel platform (5).

10. System (1) according to any of the preceding claims, in which the carousel actuator (6) is a servomotor,
and/or wherein the rotation actuator (10) is a servomotor.

11. System (1) according to any of the preceding claims, comprising three support platforms (8) rotatably connected to the carousel platform (5) around respective and distinct axes of rotation (9),
wherein the respective rotational axes (9) are parallel to each other and parallel to the carousel axis (7),
wherein, optionally, the support platforms (8) are positioned angularly equidistant with each other on the carousel platform (5),
wherein, optionally, the respective drive wheels (14) of multiple support platforms (8) are geared to the same sprocket (13),
wherein, optionally, the carousel platform (5) is a plate coaxial with the carousel axis (7), and the support platform (8) is a plate,
and wherein, optionally, at least one support platform (8) is positioned opposite a driven wheel (14) with respect to the carousel platform (5).

12. System (1) according to any of the preceding claims, wherein the carousel platform (5) comprises an upper wall (17) and an opposite lower wall (18), wherein the upper wall (17) of the carousel platform (5) faces at least one support platform (8),
wherein the system (1) includes a reflector element (19) comprising at least one reflective surface (20) positioned essentially parallel to the carousel axis (7),
wherein the reflector element (19) is connected to the top wall (17) of the carousel platform (5), at the carousel axis (7), and wherein the reflector element (19) extends along the carousel axis (7) opposite the lower wall (18) of the carousel platform (5),
wherein, optionally, the reflector (19) includes a number of reflective surfaces (20) equal to the number of support platforms (8) connected to the same carousel platform (5),
wherein, optionally, each reflective surface (20) is extended on a plane parallel to the carousel axis (7) and is positioned in line with a respective support platform (8), overlooking the respective support platform (8).

13. **System (1) according to any of the preceding claims, comprising an assembly (36) for contactless detection of the presence of a wafer (3) cassette (2) located** in **a support platform housing (8); wherein said assembly comprises:**
- a first movable element (37) intended to assume at least a first predefined position in the absence of said cassette, and at least a second predefined position, when said cassette is correctly positioned within the housing;
- a actuating mechanism (38), intended to contact said cassette and move the first movable element from said first predefined position to said second predefined position upon said contact;
- a source (39) of electromagnetic radiation;
- a sensor (40) intended to detect said electromagnetic radiation;
- a reflector (41) connected to or integral to the first movable element;
wherein the source, sensor and reflector are arranged together so that the reflector receives the electromagnetic radiation emitted from said source and reflects it onto the sensor at least when the movable element is located in the second predefined position.

14. System (1) according to claim 13, wherein the actuating mechanism (38) of the assembly (36) is integrated into at least one support platform (8) and wherein preferably the first movable element (37) is connected to or integral with said support platform (8).

15. System (1) according to claim 13 or 14, wherein the source (39) is a collimated electromagnetic radiation source, preferably a visible or infrared emitting laser.

16. System (1) according to one of claims 13-15, wherein the secondary rotation shaft (25) is hollow and said first movable element (37) is a shaft extending inside said secondary rotation shaft (25).

17. System (1) according to one of claims 13-16, wherein the assembly (36) comprises at least one guide and/or at least one spacer (42) for positioning the first movable element (37) within said secondary rotation shaft (25).

18. System (1) according to claim 17, wherein the assembly (36) comprises at least one elastic potential energy device (47) preloaded and adapted to keep said first movable element (37) in the first predefined position in the absence of a cassette.

19. System (1) according to one of claims 13-18, wherein the actuation mechanism (38) is a push-button mechanism and comprises:
- a cavity (46) located within one or more support platforms (8), where said cavity has an opening (44) located in the cassette housing of the support platform (8);
- a second movable element (43), optionally elastic, located at said opening (44) and adapted to undergo pressure under the weight of a cassette located at said opening (44) and, in response, actuate the first movable element (37), causing it to move from the first predefined position to the second predefined position.

20. An epitaxial reactor (4), comprising at least one reaction chamber and at least one wafer (3) cassette (2) loading and unloading system (1) according to any one of the previous claims,
and, optionally, wherein the epitaxial reactor (4) includes a handling robot (11) configured to handle the wafers (3) contained in the respective cassettes (2).
